# EUROPÄISCHE PATENTANMELDUNG

(11) **EP 4 814 505 A1**
(43) Veröffentlichungstag der Anmeldung: **30.09.2026**
(21) Anmeldenummer: 26156512.1
(22) Anmeldetag: 05.02.2026
(51) Int. Cl.: G01R 31/08, G01R 31/52, G01R 31/58

(54) **VERFAHREN FÜR EIN MESSSYSTEM**

(30) Priorität: 24.03.2025 DE 102025111329
(71) Anmelder: Westnetz GmbH, 44139 Dortmund (DE)
(72) Erfinder: Deutsch, Johannes, 54295 Trier (DE)
(74) Vertreter: Bals & Vogel Patentanwälte PartGmbB

(57) **Zusammenfassung**

Die Erfindung betrifft ein Verfahren zum Betreiben eines elektronischen Messsystems (1000) sowie ein entsprechendes elektronisches Messsystem (1000).

## Beschreibung

Die Erfindung betrifft ein Verfahren zum Betreiben eines elektronischen Messsystems sowie ein entsprechendes elektronisches Messsystem.

Bekannt sind (elektronische) Messsysteme, welche insbesondere portabel und/oder durch einen (menschlichen) Benutzer tragbar ausgestaltet sein können. Beispielsweise kann ein Benutzer eine Messvorrichtung und/oder eine Steuereinheit des Messsystems tragen und/oder an unterschiedlichen Messpositionen anordnen, um ein Messen von Messwerten durchzuführen. Beispielsweise kann ein Messsystem zum Messen von einem elektrischen Potential ausgebildet sein, um dadurch einen Erdschluss in einer unterhalb des Messsystems und/oder einem Untergrund (insbesondere der Erdoberfläche) verlaufenden (elektrischen) Leitung festzustellen. Dabei kann beispielsweise eine Messvorrichtung als Erdspieß und/oder Elektrode ausgebildet sein. Die Steuereinheit kann als Erdschlusssonde ausgebildet sein, und insbesondere ein Messen und/oder ein Aufprägen eines elektrischen (Mess-) Potentials erwirken, beispielsweise in Verbindung mit einer weiteren (z. B. durch ein Kabel verbundenen) Messvorrichtung. Bekannt sind zudem Messsysteme zur Detektion eines Erdschlusses und/oder von akustischen Signalen. Beispielsweise können ein Kurzschluss,
und/oder eine Stoßortung zu akustischen Signalen und/oder (elektrischen) Überschlägen führen, welche akustisch detektierbar sein können. Akustische Signale können bei einem Kurzschluss (Netzspannung) entstehen (etwa zwischen zwei oder mehr el. Leitern z.B.: Phase - Phase, oder Phase - PE(N)). Zudem entstehen akustische Signale insbesondere bei der sog. "Stoßortung". Hierbei gibt der Anwender i.d.R. Fremd-/Hochspannung auf das defekte Kabel. An der Fehlerstelle entsteht ein Lichtbogen, welcher den Schall(druck) verursacht. Ebenfalls entsteht, bedingt durch den Energiefluss zwischen (Fremd-)Spannungsquelle und Fehlerstelle (also vereinfacht gesagt durch den Stromfluss), ein Magnetfeld. Für gewöhnlich wird insbesondere beides (Schall & Magnetfeld) mit Hilfe eines sog. "Körperschallmikrofons" (Bodenmikrofons) gemessen. Vereinfacht gesagt ist der Anwender näher an der Fehlerstelle, je geringer die Zeitdifferenz zwischen Eintreffen des magnetischen Impulses und des akustischen Signals ist. Auch können Defekte an (nicht notwendigerweise elektrischen) Leitungen, etwa Rohrleitungen (für Wasser oder dergleichen) akustisch festgestellt werden. Dabei kann beispielsweise eine Messvorrichtung als Mikrofon, insbesondere als Körperschallmikrofon und/oder Bodenmikrofon, ausgestaltet sein. Die Steuereinheit kann entsprechend für eine Verarbeitung und/oder ein Messen von akustischen Signalen eingerichtet sein. Eine weitere Ausgestaltung derartiger portabler Messsysteme kann beispielsweise zur Detektion von Gasen und/oder Gaslecks ausgebildet sein. So kann beispielsweise eine Messvorrichtung zur Detektion von Gasen (in der Umgebungsluft und/oder im Erdreich bzw. Untergrund) eingerichtet sein. Die Steuereinheit kann entsprechend zur Verarbeitung von ermittelten Messwerten (bzw. Messdaten) eingerichtet sein.

Der Stand der Technik weist dabei Nachteile auf. So kann es sein, dass die oben beschriebenen Messsysteme (lediglich) integriert und/oder verkapselt ausgestaltet sind. So können die Messvorrichtung und die Steuereinheit bezüglich Hardware und/oder Software limitiert sein auf einen (unflexiblen) Anwendungsbereich. Beispielsweise kann es im Rahmen eines Messens (z. B. um einen Erdschluss festzustellen) notwendig sein, dass ein Benutzer anhand einer physischen (z. B. auf Papier eingezeichneten) Karte die Messvorrichtung zur Durchführung von (jeweiligen) Messungen an bestimmten Messpositionen anordnet. Dies kann den zeitlichen Aufwand erhöhen. Auch kann dies den Personalaufwand erhöhen. Weiterhin ist die Flexibilität derartiger Messsysteme optimierbar. Beispielsweise kann die Software nicht oder nur eingeschränkt verändert werden (z. B. während einer Wartung beim Hersteller). Dies kann die Flexibilität verringern und/oder die Kosten erhöhen. Weiterhin kann es unvorteilhaft und/oder umständlich sein, Kartendaten zu aktualisieren. Der Verlauf von Leitungen (elektrischen Leitungen, Wasserleitungen, Gasleitungen) ist teilweise nicht ausreichend genau bekannt und/oder über Kartendaten einsehbar. Fehler können nicht oder lediglich händisch (bzw. beim Messen und durch den Benutzer) erkannt und/oder ausgebessert werden. Weiterhin können derartige Kartendaten nicht digital verfügbar, veränderbar und/oder verteilbar sein. Dies kann Effizienz, Genauigkeit, Komfort und/oder Geschwindigkeit bei der Benutzung, insbesondere beim Messen, reduzieren.

Es ist daher eine Aufgabe der vorliegenden Erfindung, wenigstens einen der voranstehend beschriebenen Nachteile zumindest teilweise zu überwinden. Insbesondere ist es Aufgabe der Erfindung die Flexibilität, Kosten, Genauigkeit, Verfügbarkeit, Effizienz, Komfort, Erweiterbarkeit und/oder Geschwindigkeit zu verbessern.

Die voranstehende Aufgabe wird gelöst durch ein Verfahren mit den Merkmalen des unabhängigen Verfahrensanspruchs sowie durch ein Messsystem mit den Merkmalen des unabhängigen Systemanspruchs. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit dem erfindungsgemäßen Messsystem und jeweils umgekehrt, sodass bezüglich der Offenbarung zu den einzelnen Erfindungsaspekten stets wechselseitig Bezug genommen wird bzw. werden kann. Insbesondere gelten Vorteile, die im Rahmen des ersten und/oder zweiten Aspekts beschrieben werden, auch jeweils für den ersten und/oder zweiten Aspekt.

Die obenstehende Aufgabe wird gemäß einem ersten Aspekt gelöst durch ein Verfahren zum Betreiben eines elektronischen Messsystems, welches insbesondere portabel und/oder durch einen (menschlichen) Benutzer tragbar ausgestaltet ist, das Messsystem aufweisend:
- eine (elektronische) Steuereinheit, beispielsweise eine Erdschlusssonde,
- eine Messvorrichtung, beispielsweise einen Erdspieß und/oder eine Elektrode, welche eingerichtet, und insbesondere von der Steuereinheit ansteuerbar, ist zum Messen von Messwerten, welche spezifisch sind für eine unterhalb der Messvorrichtung, insbesondere im Untergrund, verlaufende Leitung,
das Verfahren aufweisend:
- Verbinden eines mobilen Endgeräts eines Benutzers mit einer Datenschnittstelle der Steuereinheit des Messsystems um eine Datenverbindung zwischen dem mobilen Endgerät und der Datenschnittstelle der Steuereinheit bereitzustellen,
- Übertragen von Daten von der Steuereinheit des Messsystems über die Datenverbindung an das mobile Endgerät,
- Betreiben des mobilen Endgeräts in Abhängigkeit von den Daten.

Dabei kann das Verfahren für ein elektronisches Messsystem und/oder zum Betreiben und/oder Messen durch ein elektronisches Messsystem eingerichtet sein. Das Verfahren gemäß dem ersten Aspekt kann dabei zumindest teilweise computer-implementiert sein und/oder wiederholt durchgeführt werden. Vorteilhafterweise kann bei dem Verfahren zumindest einer der beschriebenen Schritte durchgeführt werden, wobei die Schritte bevorzugt nacheinander in der angegebenen Reihenfolge oder alternativ in einer abweichenden beliebigen Reihenfolge durchgeführt werden, und ggf. auch einzelne Schritte wiederholt werden können. Vorzugsweise kann das Verfahren bei, vor und/oder (bevorzugt) während eines Betreibens bzw. einer Benutzung des elektronischen Messsystems und/oder einer Steuereinheit durchgeführt werden. Ein Betreiben des elektronischen Messsystems kann dabei ein (manuelles) Tragen, Positionieren und/oder Erfassen von Messwerten bzw. Messen umfassen. Es kann vorgesehen sein, dass das Verfahren zumindest teilweise im Rahmen einer Inbetriebnahme und/oder Wartung durchgeführt wird. Es ist denkbar, dass das Verfahren beispielsweise durchgeführt wird, wenn ein mobiles Endgerät erstmals und/oder zu Beginn einer Messung bzw. Messreihe (etwa wenn ein Erdschluss detektiert werden soll) durchgeführt wird. Auch ist es denkbar, dass das Verfahren während einer Messung und/oder Messreihe durch das Messsystem durchgeführt wird. Dabei können die Steuereinheit und/oder das mobile Endgerät das Verfahren (zumindest teilweise) implementieren, beispielsweise durch (kombiniertes) Durchführen der (oben genannten) Schritte und/oder Ansteuern und/oder Regeln entsprechender Komponenten. Durch das Verfahren können Flexibilität, Kosten, Genauigkeit, Verfügbarkeit, Effizienz, Komfort, Erweiterbarkeit und/oder Geschwindigkeit optimiert werden.

Das Messsystem kann vorzugsweise portabel und/oder durch einen (menschlichen) Benutzer tragbar ausgestaltet sein. Demnach kann ein Benutzer das Messsystem (händisch) bewegen und/oder (an einer Messposition) positionieren.

Das Messsystem kann eine (elektronische) Steuereinheit, beispielsweise eine Erdschlusssonde, aufweisen. Dabei kann die Steuereinheit einen integrierten Schaltkreis und/oder einen Computer aufweisen. Die Steuereinheit kann mechanisch und/oder elektrisch mit der Messvorrichtung verbunden sein. Im einfachsten Fall kann dabei die Steuereinheit an der Messvorrichtung befestigt sein. Die Steuereinheit kann dazu eingerichtet sein, die Messvorrichtung anzusteuern. Die Steuereinheit kann dazu eingerichtet sein, Messsignale an die Messvorrichtung bereitzustellen, beispielsweise eine (angelegte und/oder gemessene) elektrische Spannung und/oder Potentialdifferenz. Die Steuereinheit kann (auch) dazu eingerichtet sein, Messwerte bzw. empfangene Messsignale von der Messvorrichtung übermittelt zu bekommen und/oder zu verarbeiten. Es kann vorgesehen sein, dass eine Steuereinheit zumindest zwei Messvorrichtungen aufweist, wobei die Steuereinheit mit jeder der Messvorrichtungen verbunden ist (beispielsweise über ein jeweiliges Kabel und/oder eine Funkstrecke). Dadurch kann beispielsweise ein (elektrisches) Potential zwischen den Messvorrichtungen ermittelt werden. Es kann auch vorgesehen sein, dass ein Messsystem zwei Messvorrichtungen mit jeweils einer (dieser zugeordneten) Steuereinheit aufweist. Dabei können beispielsweise die Steuereinheiten über ein (physisches) Kabel und/oder eine Datenverbindung verbunden sein, beispielsweise um eine synchrone Messung zu ermöglichen. Die Messvorrichtung und/oder die Steuereinheit können einen Energiespeicher aufweisen, beispielsweise einen Akkumulator, welcher eingerichtet ist, die Messvorrichtung und/oder die Steuereinheit mit (elektrischer) Energie zu versorgen.

Die Messvorrichtung, beispielsweise umfassend einen Erdspieß und/oder eine Elektrode, kann eingerichtet, und insbesondere von der Steuereinheit ansteuerbar und/oder implementiert, sein zum (weiteren) Messen von (weiteren) Messwerten, welche insbesondere spezifisch sind für eine (potentiell und/oder externe) unterhalb der Messvorrichtung, insbesondere im Untergrund (bzw. der Erde), verlaufende (elektrische und/oder fluidführende) Leitung. Eine Leitung kann dabei unter der Erde verlegt sein. Beispielsweise kann es sich um eine elektrische und/oder spannungs- bzw. stromführende Leitung handeln. Alternativ kann das Messsystem auch für eine fluidführende Leitung, z. B. eine Gasleitung, eingerichtet sein. Die Leitung kann dabei separat und/oder extern zu dem Messsystem ausgeführt sein.

Die Messwerte können dabei eine (erfasste und/oder gemessene) Spannung, einen Strom und/oder ein akustisches Signal und/oder eine Gaskonzentration umfassen. Die Messwerte können dabei von der Messvorrichtung erfasst werden. Demnach kann die Messvorrichtung als Sensor und/oder Detektor verstanden werden. Die Steuereinheit kann dabei die Messwerte von der Messvorrichtung übermittelt bekommen (etwa über eine (elektrische) Signal- und/oder Datenverbindung) und diese weiterverarbeiten. Die Messwerte sind vorzugsweise spezifisch für eine unterhalb der Messvorrichtung, insbesondere im Untergrund, verlaufende Leitung. Mit anderen Worten kann die Steuereinheit, das mobile Endgerät und/oder der Benutzer anhand der Messwerte einen Verlauf und/oder einen Defekt der Leitung feststellen.

Beispielsweise kann die Messvorrichtung als Elektrode und/oder (elektrisch leitender) Erdspieß ausgestaltet sein. Dabei kann die Steuereinheit als Erdschlusssonde ausgestaltet sein. Die Steuereinheit kann mit der Messvorrichtung elektrisch verbunden sein. Dadurch kann die Messvorrichtung Messwerte, insbesondere ein elektrisches Potential (über die Zeit), ermitteln, ggf. im Zusammenwirken mit einer weiteren Messvorrichtung bzw. einer weiteren Elektrode bzw. einem weiteren Erdspieß. Die Steuereinheit kann die Messwerte speichern und/oder weiterverarbeiten. Die Steuereinheit, das mobile Endgerät und/oder der Benutzer kann in Abhängigkeit von den (an diese übermittelten) Messwerten beispielsweise einen Erdschluss und/oder Defekt (der Leitung) detektieren.

Beispielsweise kann die Messvorrichtung als Lautsprecher und/oder Mikrofon ausgestaltet sein. Demnach kann die Messvorrichtung einen elektroakustischen Wandler aufweisen. Dadurch können Schallwellen durch die Messvorrichtung in den Untergrund abgegeben und/oder aus diesem empfangen werden. Auch können Schallwellen (aus dem Untergrund) durch die Messvorrichtung erfasst werden. Demnach können die Messwerte spezifisch sein für Schallwellen, welche beispielsweise bei (elektrischen) Überschlägen einer (defekten) Leitung im Untergrund entstehen. Die Messwerte können dabei auch spezifisch sein für Schallwellen, die auf einen andersartigen Leitungsdefekt hinweisen, beispielsweise eine Undichtigkeit einer fluidführenden Leitung, welche z. B. rohrartig ausgebildet ist (etwa eine Wasserleitung oder Gasleitung). Dabei kann die Steuereinheit eingerichtet sein, derartige Messwerte übermittelt zu bekommen und/oder zu verarbeiten. Beispielsweise kann die Messvorrichtung dazu eingerichtet sein, die Schallwellen in elektrische Signale bzw. Messwerte umzuwandeln (oder umgekehrt). Die Steuereinheit kann mit der Messvorrichtung elektrisch verbunden sein. Dadurch kann die Messvorrichtung Messwerte, insbesondere eine elektrische Spannung (über die Zeit), ermitteln. Die Steuereinheit kann die Messwerte speichern und/oder weiterverarbeiten. Die Steuereinheit, das mobile Endgerät und/oder der Benutzer kann in Abhängigkeit von den (an diese übermittelten) Messwerten beispielsweise einen Erdschluss und/oder einen Leitungsdefekt (etwa ein Gasleck) detektieren.

Das Verfahren kann ein Verbinden eines mobilen Endgeräts eines Benutzers mit einer Datenschnittstelle der Steuereinheit des Messsystems umfassen, wodurch eine Datenverbindung zwischen dem mobilen Endgerät und der Datenschnittstelle der Steuereinheit bereitgestellt werden kann, insbesondere um dadurch einen Austausch von Daten, Steuersignalen, Messsignalen und/oder Messwerten zu ermöglichen. Der Benutzer ist dabei vorzugsweise nicht von dem Messsystem umfasst. Der Benutzer kann beispielsweise ein Vermessungsingenieur, Elektroingenieur, Planungsingenieur und dergleichen sein. Das mobile Endgerät kann beispielsweise ein Smartphone oder einen (Tablet-) Computer oder ein derartiges Gerät aufweisen. Das Verbinden kann eine Datenverbindung für einen (bidirektionalen) Datenaustausch bereitstellen. Beispielsweise kann die Datenverbindung dabei kabelgebunden und/oder kabellos ausgestaltet sein, und insbesondere umfassen:
- LAN (Local Area Network), insbesondere Ethernet (Institute of Electrical and Electronics Engineers Inc.),
- Kabelgebunden z. B. über ein USB-C Kabel,
- WLAN (Wireless LAN),
- Bluetooth,
- einfach oder doppelt ausgeführter CAN-Bus (Controller Area Network),
- PROFINET,
- FlexRay-Bus, und/oder
- optische Verbindung, insbesondere Glasfaser.

Die Datenverbindung kann eine Übertragung von (digitalen) Daten bereitstellen, insbesondere basierend auf (getakteten) Datenpaketen, beispielsweise umfassend eine Zieladresse und eine Absenderadresse. Auf diese Weise kann ein Datenaustausch zwischen der Steuereinheit und dem mobilen Endgerät bereitgestellt werden.

Vorzugsweise kann das Verbinden als erster Schritt vorgenommen werden, wenn das mobile Endgerät mit dem Messsystem gekoppelt wird. Dabei kann beispielsweise ein Benutzer sein eigenes bzw. personalisiertes mobiles Endgerät besitzen, welches bei Benutzung des Messsystems mit der Steuereinheit durch ein Verbinden gekoppelt wird. Dadurch kann vorteilhafterweise auch nachvollzogen werden, wann welcher Benutzer welches Messsystem verwendet hat.

Das Verbinden kann, insbesondere vorher, nachher oder währenddessen, ein Herunterladen von Daten, Kartendaten und/oder Messposition(en), insbesondere über eine Datenverbindung, beispielsweise das Internet, von einer Backend-Recheneinheit umfassen, insbesondere auf das mobile Endgerät und/oder auf die Steuereinheit (über das mobile Endgerät). Dabei kann vorteilhafterweise das mobile Endgerät als Kommunikationsschnittstelle bzw. Sende- und/oder Empfangseinheit für die Steuereinheit verwendet werden. Dadurch können vorteilhafterweise vorhandene Steuereinheiten flexibler und/oder häufiger mit neuen Updates und/oder Daten, z. B. Kartendaten, versorgt werden.

Das Übertragen von Daten von der Steuereinheit des Messsystems über die Datenverbindung an das mobile Endgerät, kann dabei automatisch erfolgen. So kann beispielsweise unmittelbar nach dem Verbinden ein Übertragen erfolgen. Hierbei können die Daten eingerichtet sein, das Messsystem, die Steuereinheit und/oder die Messvorrichtung bei dem mobilen Endgerät zu registrieren. Die Daten (und/oder die zumindest eine Messspezifikation) können aufweisen:
- (weitere und/oder historische) Messwerte, insbesondere (gemessene) Rohdaten (z. B. elektrische Potential[e]), (durch die Steuereinheit) verarbeitete Messwerte und/oder Zeitinformationen (z. B. Messzeitpunkte)
- Statusinformationen, welche spezifisch sind für das Messsystem, die Steuereinheit und/oder die Messvorrichtung, beispielsweise umfassend Betriebszustand (z. B. funktionsfähig, defekt, fehlerbehaftet), Energieversorgung (z. B. Akkuladestand), Diagnosedaten (z. B. Fehlermeldungen, Wartungsbedarf, Sensorstatus), Kalibrierstatus (z. B. Zeitpunkt der letzten Kalibrierung und/oder Abweichungen)
- Konfigurationsdaten (z. B. Abtastrate, Messempfindlichkeit, Messeinstellungen), die insbesondere spezifisch sind für ein Messen,
- Identifikationsdaten (z. B. Seriennummer, Identifikationskennung, Software-Version, Firmware-Version, Gerätetyp und/oder Modellnummer), und/oder
- Kommunikationsdaten (z. B. Verbindungsstatus, Verbindungsarten, Signalqualität, Protokollinformationen, Datenrate).

Die Daten können dabei, insbesondere nach einem Verbinden, fortwährend übertragen werden. Insbesondere können durch das (weitere) Messen erfasste Messwerte (direkt) an das mobile Endgerät übermittelt werden. Das mobile Endgerät kann dabei die Daten in einem internen Speicher und/oder, bspw. über ein (mobiles) Datennetz (LTE, WLAN, ...), die Daten in einen (zentralen) Speicherort [z.B. (unternehmenseigner) (Web-)Server, Cloud, ..] (ab)speichern bzw. übermitteln und/oder auf vergangene bzw. bereits übermittelte Daten zugreifen. Das mobile Endgerät kann eine Software aufweisen, welche eingerichtet ist, die Daten zu empfangen, zu verarbeiten, zu bearbeiten, zu visualisieren und/oder zu speichern. In Abhängigkeit von den Daten kann das mobile Endgerät das Messsystem, die Steuereinheit und/oder die Messvorrichtung erkennen und/oder registrieren.

Das mobile Endgerät kann in Abhängigkeit von den Daten ein Betreiben durchführen. Es kann dabei vorgesehen sein, dass das mobile Endgerät (über die Steuereinheit) die Messvorrichtung betreibt, beispielsweise durch Steuersignale, welche zu einem Anlegen einer Messspannung an der Messvorrichtung (durch die Steuereinheit) führen. Es kann auch vorgesehen sein, dass das mobile Endgerät die Steuereinheit ansteuert, beispielsweise durch entsprechende Steuersignale, woraufhin die Steuereinheit die Messvorrichtung betreibt. Dabei kann die Steuereinheit zumindest teilweise überbrückt werden, wobei vorzugsweise das mobile Endgerät, insbesondere durch den Benutzer, zum Betreiben des Messsystems (z. B. zum Initiieren eines Messens) verwendet werden kann. So kann beispielsweise das Steuergerät (nur noch) als untergeordnete Einheit (Slave) des mobilen Endgeräts (Master) verwendet werden. Beispielsweise kann die Steuereinheit lediglich Messsignale erzeugen (z. B. eine Messspannung) und Messwerte empfangen (und direkt weiterleiten an das mobile Endgerät). Vorteilhafterweise kann (dadurch) dem Benutzer eine verbesserte und/oder gewohntere (/ einheitlichere) Bedienoberfläche bereitgestellt werden. Zudem können vorteilhafterweise weitere Funktionen durch das mobile Endgerät bereitgestellt werden. Mit anderen Worten kann dabei die Steuereinheit über einen limitierten bzw. rudimentären Funktionsumfang verfügen, beispielsweise lediglich das Erfassen von einzelnen Messwerten. Demnach kann die Steuereinheit (im Vergleich zu dem Funktionsumfang des mobilen Endgeräts) "dumm" ausgestaltet sein. Durch das Betreiben des mobilen Endgeräts in Abhängigkeit von den (übermittelten) Daten sind unterschiedliche Arten der Benutzung, das Messen von Messwerten und/oder Visualisieren von Daten bzw. Messwerten möglich. Dadurch kann vorteilhafterweise ein Messen effizienter durchgeführt werden.

Im Rahmen der Erfindung kann es von Vorteil sein, dass das Verbinden ein mechanisches Anordnen des mobilen Endgeräts in einer dafür eingerichteten Halterung aufweist, wobei die Halterung an dem Messsystem, insbesondere an der Steuereinheit und/oder der Messvorrichtung, angeordnet ist, wobei vorzugsweise gleichzeitig das mechanische Anordnen und das Verbinden des mobilen Endgeräts mit der Datenschnittstelle durchgeführt wird.

Dabei kann die Halterung eine komplementäre Form zu dem mobilen Endgerät aufweisen. Dadurch kann das mobile Endgerät kraft- und/oder formschlüssig reversibel lösbar und/oder verliersicher befestigt werden. Beispielsweise kann die Halterung an einem oberen Ende der Messvorrichtung angeordnet sein, insbesondere, wenn diese als Elektrode und/oder Erdspieß ausgestaltet ist. Es kann vorgesehen sein, dass die Halterung verstellbar eingerichtet ist, so dass vorteilhafterweise unterschiedlich dimensionierte mobile Endgeräte aufgenommen werden können. Dabei kann die Halterung einen Stecker (oder eine Buchse) aufweisen, welche komplementär zu einer Buchse (oder einem Stecker) des mobilen Endgeräts ausgebildet ist. Vorzugsweise kann gleichzeitig eine mechanische Anordnung des mobilen Endgeräts an und/oder in der Halterung und ein Verbinden (um eine Datenverbindung bereitzustellen, und / oder das mobile Endgerät zu laden) erfolgen. **Im** einfachsten Fall kann die Halterung dabei als Klammer ausgebildet sein. Es kann vorgesehen sein, dass die Halterung (gleichzeitig) für eine Stromversorgung des mobilen Endgeräts eingerichtet ist. Vorzugsweise können bei dem Verbinden eine Datenverbindung und eine Stromverbindung (für das mobile Endgerät) bereitgestellt werden.

Im Rahmen der Erfindung ist es denkbar, dass bei dem Übertragen (und/oder insbesondere einem weiteren Übertragen) die Daten von der Steuereinheit über die Datenverbindung an das mobile Endgerät übermittelt werden, und das Betreiben, ein Visualisieren der Daten, insbesondere von Messwerten (und/oder weiteren Messwerten), (für den Benutzer) auf einer Anzeigeeinheit des mobilen Endgeräts (anschließend) umfasst.

Demnach kann der Benutzer über das mobile Endgerät die Daten (visuell) ansehen und/oder eine geeignete Darstellung wählen. Im einfachsten Fall können bereits in der Steuereinheit gespeicherte Daten, insbesondere Messwerte, visualisiert werden. Es kann anschließend vorgesehen sein, dass weitere Daten, insbesondere weitere Messwerte, erfasst werden (etwa durch ein [weiteres] Messen). Diese können ebenfalls an das mobile Endgerät übermittelt werden. Anschließend können diese ebenfalls visualisiert werden. Messwerte (bzw. weitere Messwerte) können dabei beispielsweise gemessene Spannungen und/oder Potentialdifferenzen aufweisen. Es kann auch vorgesehen sein, dass Messwerte akustische Signale umfassen. Es kann vorgesehen sein, dass (weitere) Messwerte (erst) von der Steuereinheit an das mobile Endgerät übermittelt werden, nachdem ein Messen durchgeführt wurde, welches insbesondere durch Ansteuern des Messsystems, insbesondere der Steuereinheit, durch das mobile Endgerät realisiert werden kann (vorzugsweise im Rahmen eines Master/Slave-Betriebs). Die Messwerte können dabei für die Leitung, insbesondere einen Defekt der Leitung, spezifisch sein. So können im Rahmen eines Erdschlusses einer (elektrischen) Leitung im Untergrund beispielsweise Potentialunterschiede von unterschiedlichen (vorzugsweise oberhalb entlang der Leitung verlaufenden) Messpositionen auf einen Defekt (insbesondere einen Erdschluss, also einen Kurzschluss zu Masse) festgestellt werden. Dies kann durch die Interpretation und/oder Erfahrung des Benutzers, beispielsweise beim Betrachten der visualisierten Messwerte, erfolgen. Bevorzugt kann es vorgesehen sein, dass das mobile Endgerät ein Detektieren eines Leitungsdefekts (zusätzlich oder alternativ) durchführt. Dabei kann das mobile Endgerät ein Auswerten der (von der Steuereinheit) übermittelten Messwerte durchführen. So kann beispielsweise eine Mustererkennung in Abhängigkeit der Messwerte durchgeführt werden. Es kann auch vorgesehen sein, dass ein Anfitten einer Kurve an die ermittelten Messwerte durchgeführt wird, beispielsweise um einen Nulldurchgang eines Potentialverlaufs zu ermitteln. Es kann auch vorgesehen sein, dass das mobile Endgerät beim Auswerten, beispielsweise bei Unterschreiten eines Grenzwerts, ein (zumindest teilweise) erneutes bzw. weiteres Messen erkennt, und insbesondere den Benutzer (über die Anzeigeeinheit) auffordert, ein weiteres Messen, beispielsweise an einer Auswahl von Messpositionen, durchzuführen. Dadurch kann vorteilhafterweise ein Leitungsdefekt (noch) genauer und/oder zuverlässiger ermittelt werden. Ein detektierter Leitungsdefekt kann, insbesondere nach Validierung und/oder Plausibilisierung durch den Benutzer und/oder das mobile Endgerät, auf dem mobilen Endgerät gespeichert werden und/oder an einen Backend-Rechner und/oder weitere mobile Endgeräte und/oder Steuereinheiten übermittelt werden.

Es kann im Rahmen der Erfindung vorgesehen sein, dass bei dem Übertragen von Daten zumindest eine Messspezifikation von der Steuereinheit über die Datenverbindung an das mobile Endgerät übermittelt wird, wobei die zumindest eine Messspezifikation für das Messsystem, die Messvorrichtung und/oder die Steuereinheit, insbesondere ein Messen des Messsystems, spezifisch ist, wobei vorzugsweise die zumindest eine Messspezifikation aufweist:
- eine, insbesondere abstandsabhängige, Messgenauigkeit,
- eine Messauflösung,
- eine Messrate (z. B. Anzahl der Messwerte pro Sekunde, Taktung der Messwerte und/oder deren Übermittlung),
- eine Messtoleranz,
- eine Reichweite, welche insbesondere spezifisch ist für das Messen, und/oder
- zumindest eine Temperatur, insbesondere einen Temperaturbereich, vorzugsweise für ein Messen.

Die Messgenauigkeit kann beispielsweise von einem Abstand zu der Leitung und/oder zu anderen leitenden Gegenständen abhängen. Das mobile Endgerät kann in Abhängigkeit von der Messgenauigkeit und den Kartendaten (siehe unten) ein Kalibrieren durchführen und/oder (durch das Messen ermittelte) Messwerte entsprechend skalieren. Es kann vorgesehen sein, dass das mobile Endgerät, insbesondere in Echtzeit, ein Kalibrieren des Messsystems und/oder der Steuereinheit durchführt. Dabei kann das Kalibrieren in Abhängigkeit von den Daten und/oder der zumindest einen Messspezifikation durchgeführt werden. Dadurch können vorteilhafterweise Temperaturschwankungen, Messschwankungen und/oder andere Störeinflüsse zumindest teilweise kompensiert werden. Das Kalibrieren kann dabei in Abhängigkeit von auf dem mobilen Endgerät durchgeführten Simulationen erfolgen. Beispielsweise kann anhand der Kartendaten und einer Ist-Position und einer Messgenauigkeit (und/oder Messauflösung und/oder Messtoleranz etc.) ein erwarteter Messwert berechnet werden. Dieser kann zum Kalibrieren verwendet werden, insbesondere basierend auf Messwerten deren Korrektheit durch den Benutzer bestätigt wurde (etwa an einer zuverlässig intakten Stelle oberhalb der Leitung). Dadurch kann vorteilhafterweise die Genauigkeit beim Detektieren eines Leitungsdefekts und/oder der exakten Position der verlegten Leitung verbessert werden. Auch kann ein Anzeigen und/oder Visualisieren unterschiedlicher Methoden und/oder Informationen ermöglicht werden. So kann eine Verwendung vorgesehen sein beispielsweise auch bei der sog. "(Kabel-)Trassenortung", bei der die exakte Position der verlegten Leitung, z. B als Position (dies könnte bspw. mit Hilfe GPS direkt ins Planwerk übertragen werden) und/oder in Relation zur Erdoberfläche (Tiefenangabe) angezeigt werden kann.

Es ist ferner denkbar, dass das Betreiben des mobilen Endgeräts in Abhängigkeit von den Daten durchgeführt wird, wobei das mobile Endgerät, insbesondere in Abhängigkeit von der zumindest einen Messspezifikation, ein Bereitstellen eines Messplans (für ein anschließendes Messen) durchführt, umfassend (zumindest):
- eine Vielzahl von Messpositionen für das Messen an spezifischen Positionen bzw. Orten, insbesondere oberhalb des Untergrunds und/oder entlang der (vermeintlichen Position der) Leitung, insbesondere in Abhängigkeit von in dem mobilen Endgerät gespeicherten Kartendaten, und/oder
- wobei insbesondere jede der Vielzahl von Messpositionen zumindest eine, insbesondere für ein Messen spezifische, Messcharakteristik aufweist, insbesondere eine Messreihenfolge, eine Messzeit und/oder eine Messart.

Der Messplan kann dabei spezifisch sein für ein (anschließend) vorzunehmendes Messen von Messwerten und/oder einen Ablauf zur Detektion eines Leitungsdefekts der Leitung. Beispielsweise kann der Benutzer mit dem Messsystem (nach dem Bereitstellen des Messplans) anhand des Messplans die Vielzahl an Messpositionen (beim und/oder für das Messen) ablaufen (zu Fuß) und jeweils an jeder Messposition der Vielzahl von Messpositionen ein Messen eines oder mehrere Messwerte(s) durchführen. Dabei sind die (ist die Vielzahl von) Messpositionen beispielsweise GPS-Daten, welche vorzugsweise (unmittelbar und/oder senkrecht) oberhalb der Leitung (z. B. gemäß der in den Kartendaten vermerkten Informationen bezüglich des Verlaufs der Leitung) angeordnet sein können. Dabei kann das Bereitstellen des Messplans in Abhängigkeit von den Daten (siehe oben) und/oder Messspezifikationen (siehe oben) durchgeführt werden, wobei insbesondere das mobile Endgerät den Messplan berechnet. Dabei kann beispielsweise ein vermuteter Leitungsdefekt in einem bestimmten Leitungsabschnitt (z. B. zwischen zwei GPS-Koordinaten auf einer Länge von bspw. 100 m) der Leitung zugrunde gelegt werden. In Abhängigkeit von den Kartendaten, den Daten und/oder der zumindest einen Messspezifikation, kann das mobile Endgerät (anschließend) einen Messplan berechnen. Dabei kann es vorgesehen sein, dass der Messplan (zumindest teilweise) vorberechnet ist, beispielsweise basierend auf Simulationen (von möglichen Leitungsdefekten) und/oder unabhängig von den Daten und/oder der zumindest einen Messspezifikation. Dies kann vorteilhaft sein, um einen vorberechneten Messplan beispielsweise auf einem Großrechner und/oder einer Backend-Recheneinheit anzufertigen und lediglich (zum Nachjustieren und/oder Verfeinern vor Ort) auf das mobile Endgerät zu übertragen. Alternativ kann das mobile Endgerät den Messplan (vor Ort) berechnen. Dabei kann beispielsweise ein Kalibrieren (siehe oben) berücksichtigt werden. Vorteilhafterweise kann dabei der Messplan dahingehend optimiert werden, dass eine minimale Anzahl an Messpositionen notwendig ist. Bei bekannten Messsystemen kann es vorgesehen sein, dass der Benutzer, beispielsweise aufgrund von Erfahrung (welche nicht jeder Benutzer hat), eine Vielzahl an Messpositionen auswählt, dort Messwerte erfasst und dadurch einen Leitungsdefekt (grob) ortet. Dies kann dazu führen, dass zu viele Messpositionen vermessen werden, die falschen Messpositionen vermessen werden und/oder die Messgenauigkeit unzureichend sein kann. Durch Bereitstellen eines, insbesondere für die (digitalen) Kartendaten spezifischen, Messplans, kann vorteilhafterweise die Genauigkeit, Effizienz und/oder Geschwindigkeit verbessert werden. Beispielsweise kann der Messplan in Abhängigkeit von der Messgenauigkeit und/oder der Reichweite des Messsystems die Vielzahl von Messpositionen ermitteln. So können beispielsweise anfänglich größere (räumliche) Abstände zwischen den Messpositionen verwendet werden, um beispielsweise einen Leitungsdefekt (und eine weitere Detektion) auf einen (kleineren) Leitungsabschnitt zu beschränken und/oder um die Kartendaten zu validieren. Anschließend können (in Abhängigkeit von ermittelten Messwerten) weitere Messpositionen der Vielzahl an Messpositionen berechnet werden. Dadurch kann beispielsweise die Anzahl der Messpositionen (der Vielzahl von Messpositionen) minimiert werden. Um ein einfaches Beispiel zu beschreiben kann (vereinfacht) eine Leitung angenommen werden, welche an drei unterschiedlichen Positionen in den Kartendaten in geringerer Tiefe verlegt ist als in den übrigen Leitungsabschnitten. Dabei kann der Messplan entsprechend derart bereitgestellt werden, dass die Vielzahl der Messpositionen (zuerst) Messpositionen oberhalb dieser beschriebenen Positionen aufweist. Nachdem (in Abhängigkeit z. B. von den dort gemessenen Messwerten) der Defekt auf einen Leitungsabschnitt eingeschränkt ist, können die Vielzahl der Messpositionen sich auf diesen Leitungsabschnitt beschränken, wiederum bevorzugt dahingehend, dass die Anzahl der Messungen und/oder die Genauigkeit der Defektlokalisation optimiert werden. Einige oder jede der Vielzahl von Messpositionen kann zumindest eine, insbesondere für ein Messen spezifische, Messcharakteristik aufweisen, insbesondere eine Messreihenfolge, eine Messzeit und/oder eine Messart. Demnach kann die Vielzahl der Messpositionen in einer bestimmten Reihenfolge vorgesehen sein (siehe oben). Zusätzlich oder alternativ kann die Messzeit (jeweils) festgelegt sein, um insbesondere (etwa anhand eines Grenzwerts) ausreichende Messgenauigkeit zu erzielen (etwa durch Messwiederholung und/oder Mittelung). Zudem kann eine Messart vorgesehen sein, beispielsweise ob eine (einzige) Messvorrichtung verwendet werden soll oder ob (potentiell) eine weitere Messvorrichtung eingesetzt werden soll und insbesondere wo diese positioniert werden soll (z. B. GPS-Daten). Alternativ oder zusätzlich kann durch die Messart beispielsweise ein Frequenzspektrum angepasst und/oder vorgegeben werden, beispielsweise für eine Potentialmessung und/oder eine Tonsendeanlage. Auch kann dadurch eine Leistungsanpassung und/oder ein Anpassen bzw. vorgeben einer Signalform erfolgen. Dadurch kann vorteilhafterweise die Genauigkeit und/oder die Anzahl der (notwendigen) Messpositionen (weiter) reduziert werden. Es kann vorgesehen sein, dass das Bereitstellen ein Übertragen des Messplans an eine Backend-Recheneinheit aufweist, beispielsweise um den Messplan zu validieren, insbesondere durch aktuellere Kartendaten und/oder weitere aktuelle Informationen.

Auch ist es denkbar, dass das Betreiben des mobilen Endgeräts, insbesondere das Bereitstellen des Messplans, ein Anzeigen des Messplans umfasst, insbesondere der Vielzahl von Messpositionen von welchen (vorzugsweise) eine aktuelle Messposition dargestellt wird, beispielsweise auf einer Anzeigeeinheit des mobilen Endgeräts, wobei vorzugsweise eine (notwendige) Bewegungsrichtung (für den Benutzer) hin zu der aktuellen Messposition in Abhängigkeit von einer durch das mobile Endgerät ermittelten Ist-Position dargestellt wird.

Eine Messposition (der Vielzahl an Messpositionen), eine aktuelle Messposition und/oder eine Ist-Position können dabei GPS-Daten oder ähnliche standardisierte Positionsangaben / Geodaten aufweisen, insbesondere oberhalb und/oder auf dem Untergrund und/oder der Erdoberfläche. Vorzugsweise kann die Ist-Position eine momentane und/oder aktuelle Position des mobilen Endgeräts und/oder (damit) der Steuereinheit und/oder der Messvorrichtung aufweisen. Eine aktuelle Messposition kann dabei eine als nächstes einzunehmende Messposition, insbesondere der Vielzahl der Messpositionen, aufweisen, beispielsweise eine Messposition, welche gemäß der Reihenfolge der Vielzahl von Messpositionen als nächstes verwendet werden soll (um dort Messwerte zu erfassen). Der Messplan kann, insbesondere auf der Anzeigeeinheit des mobilen Endgeräts, (für den Benutzer) angezeigt werden, beispielsweise anhand einer Draufsicht und/oder einer Messkarte (auf welcher die Vielzahl der Messpositionen eingezeichnet ist). Dabei kann, beispielsweise in einem Messmodus (in welchen das mobile Endgerät bringbar und/oder einstellbar ist), die aktuelle Messposition angezeigt werden, zu welcher sich der Benutzer vorzugsweise als nächstes begeben soll. Dabei kann das mobile Endgerät (laufend) ein Vergleichen zwischen aktueller Messposition und der Ist-Position durchführen. Dadurch kann eine Bewegungsrichtung und/oder eine Distanz (zu der aktuellen Messposition) für den Benutzer bereitgestellt werden. Dadurch kann vorteilhafterweise die Orientierung für den Benutzer vereinfacht werden, die Effizienz und/oder die Geschwindigkeit verbessert werden. Es kann vorgesehen sein, dass bei Erreichen der aktuellen Messposition, und/oder bei Übereinstimmen der aktuellen Messposition und der Ist-Position, (automatisch) ein Messen durchgeführt wird. Alternativ kann der Benutzer das Erreichen und/oder die Messbereitschaft (manuell), z. B. über die Anzeigeeinheit (etwa einen Touchscreen) bestätigen, oder bereits gemessene Daten (Potentialdifferenz, Positions/Tiefenangabe, etc.) als Messpunkt gespeichert werden. Dadurch kann ein Messen in Abhängigkeit von dem Messplan erfolgen, wobei an jeder der Vielzahl von Messpositionen jeweils zumindest ein Messen eines Messwerts (bzw. von Messwerten) und/oder eines elektrischen Parameters, insbesondere eines Potentials (z. B. bei einer Erdschlusssonde), durch das Messsystem durchgeführt wird, wobei insbesondere die bei dem Messen gemessenen Messwerte durch ein (weiteres) Übertragen von der Steuereinheit (über die Datenschnittstelle) an das mobile Endgerät übermittelt werden. Dabei kann das mobile Endgerät beim Messen und/oder für das Messen die Steuereinheit ansteuern, woraufhin diese vorzugsweise einen oder mehrere Messwerte erfasst. Durch das Messen anhand des Messplans kann somit die Genauigkeit und/oder Effizienz verbessert werden. Dadurch kann auch unerfahrenen Benutzern eine Handhabung des Messsystems ermöglicht werden. Es kann (zusätzlich) vorgesehen sein, dass der Benutzer über das mobile Endgerät Unterstützung, beispielsweise durch einen erfahrenen Benutzer bekommt, insbesondere im Rahmen eines Remote-Control und/oder einer Fremdsteuerung (durch den erfahrenen Benutzer).

**Im** Rahmen der Erfindung ist es optional möglich, dass bei dem Betreiben, insbesondere dem Anzeigen, der Benutzer an zumindest einer (oder allen) der Vielzahl von Messpositionen, insbesondere an einer aktuellen Messposition der Vielzahl an Messpositionen, ein Messen von Messwerten mit dem Messsystem durchführt.

Demnach kann (der Reihe nach) ein (weiteres) Messen von (weiteren) Messwerten an den (weiteren) Messpositionen (der Vielzahl von Messpositionen) durchgeführt werden. Dabei kann, insbesondere bei Erreichen der Messposition, ein (automatisches) Messen durchgeführt werden. Alternativ kann ein Starten des Messens nach Bestätigung durch den Benutzer erfolgen, dass die Messvorrichtung korrekt platziert wurde. Die Messwerte können bevorzugt von der Steuereinheit erfasst und an das mobile Endgerät übermittelt werden.

Ferner kann es im Rahmen der Erfindung vorgesehen sein, dass bei dem Messen ein Ansteuern der Messvorrichtung und/oder der Steuereinheit durch das mobile Endgerät durchgeführt wird, woraufhin vorzugsweise die Messvorrichtung, insbesondere (angesteuert und/oder betrieben) durch die Steuereinheit, zumindest einen Messwert bzw. Messwerte ermittelt und an die Steuereinheit überträgt, welche insbesondere den zumindest einen Messwert an das mobile Endgerät übermittelt.

Es ist auch denkbar, dass der Messplan durch die Steuereinheit während des Messens und/oder nach Abschluss der Messungen nachjustiert wird. Dies kann beispielsweise zum Validieren der Messergebnisse vorteilhaft sein. Dadurch kann vorteilhafterweise die Genauigkeit erhöht werden.

**In** Bezug auf die vorliegende Erfindung ist es vorstellbar, dass das Betreiben, wenn die aktuelle Messposition nicht mit der durch das mobile Endgerät ermittelten Ist-Position übereinstimmt, umfasst:
- Sperren des Messens, insbesondere durch das mobile Endgerät (z. B. durch ein Sperrsignal, welches an die Steuereinheit übermittelt wird), und/oder
- Ausgeben eines akustischen Warnsignals durch das mobile Endgerät (z. B. einen Lautsprecher) an den Benutzer, und/oder,
- Anzeigen, insbesondere auf einer Anzeigeeinheit des mobilen Endgeräts, einer Fehlermeldung und/oder insbesondere einer Anleitung zur Behebung des Sperrens (für den Benutzer).

Es kann vorgesehen sein, dass beispielsweise ein Anzeigen einer (notwendigen) Bewegungsrichtung und/oder Angabe von Entfernung zwischen der (aktuellen) Ist-Position und der (vorgesehenen) aktuellen Messposition (quasi der Soll-Position) umfasst.

Es kann vorgesehen sein, dass das mobile Endgerät, insbesondere auf der Anzeigeeinheit, unterschiedliche Daten parallel anzeigt. So kann beispielsweise (etwa in einem "Splitscreen-Modus") eine (notwendige) Bewegungsrichtung einerseits und eine Visualisierung der (Mess- )Daten andererseits erfolgen. Dies kann den Bedienkomfort verbessern.

Es kann vorgesehen sein, dass ein Messen dabei (nur) ermöglicht wird, wenn eine Messposition durch das mobile Endgerät freigegeben wird, beispielsweise nach einem (erfolgreichen) Abgleichen von Ist-Position und aktueller Messposition (z. B. wenn die Abweichung weniger als einen Grenzwert beträgt, etwa weniger als (bspw.) 10-100 cm). Es kann vorgesehen sein, dass alternativ ein Sperren eines Messens erfolgt, wobei insbesondere das mobile Endgerät ein Sperrsignal an die Steuereinheit übermitteln kann, um ein Messen zu unterbinden. Dadurch kann vorteilhafterweise ein unnötiger Energieverbrauch reduziert werden, was insbesondere die mögliche Messzeit verlängern kann und/oder Gewichtseinsparungen bei der Energiequelle (z. B. ein leichterer Akku) ermöglichen kann.

Ferner ist es vorstellbar, dass in dem mobilen Endgerät bereitgestellte Kartendaten vorgesehen sind, welche zumindest spezifisch sind für den Verlauf zumindest einer (externen und/oder unterirdisch verlegten) Leitung, insbesondere im Untergrund (und/oder der Erde) unterhalb des Messsystems bzw. der Messvorrichtung, wobei insbesondere der Messplan spezifisch ist für die Kartendaten, insbesondere den Verlauf der zumindest einen Leitung (gemäß den Kartendaten), und vorzugsweise die Vielzahl von Messpositionen entlang und/oder oberhalb (des Untergrunds) von der zumindest einen Leitung aufweist.

Die Kartendaten können gespeichert sein in (einem Speicher von) dem mobilen Endgerät. Dadurch können vorteilhafterweise die Kartendaten (laufend) aktualisiert werden, beispielsweise über eine (zweite) Datenverbindung, etwa das Internet. Es kann vorgesehen sein, dass die Kartendaten (anfänglich, fortlaufend und/oder wiederholt) durch ein Übertragen, insbesondere über eine (zweite) Datenverbindung, von einer Backend-Recheneinheit an das mobile Endgerät übermittelt werden. Dabei kann der (vermeintliche) Verlauf der Leitung in den Kartendaten umfasst sein. Die Kartendaten können weiterhin andere Leitungen, z. B. andere elektrische Leitungen, fluidführende Leitungen etc., Gebäude (oberhalb und/oder unterhalb des Untergrunds), Straßen, Wege, Versorgungsschächte, Tiefeninformationen und/oder (jeweils entsprechende) (GPS-)Positionen aufweisen. Mit anderen Worten können die Kartendaten eine virtuelle Wiedergabe der Umgebung aufweisen, in welcher das Messen erfolgen soll. So können beispielsweise unterschiedliche Leitungsabschnitte der Leitung unterschiedliche (nebeneinanderliegende) GPS-Positionen aufweisen, welche die Position der Leitung(sabschnitte) in und/oder oberhalb der Erde bzw. des Untergrunds aufweisen.

Im Rahmen der Erfindung kann es von Vorteil sein, dass, insbesondere bei und/oder nach dem Betreiben, ein Nachjustieren der Kartendaten durchgeführt wird, insbesondere in Abhängigkeit von den (ermittelten) Messwerten, wobei der Verlauf der zumindest einen Leitung in den Kartendaten zumindest teilweise durch einen aktualisierten Verlauf der zumindest einen Leitung in den Kartendaten angepasst wird, um aktualisierte Kartendaten zu erhalten, wobei insbesondere das Nachjustieren umfasst:
- ein Vergleichen der Messwerte mit historischen Messwerten, vorzugsweise an einer identischen (z. B. historischen bzw. früher vermessenen) Messposition, und/oder
- ein Vergleichen einer Ist-Position, welche vorzugsweise durch eine Ortungseinheit, beispielsweise einen GPS-Sensor, des mobilen Endgeräts bestimmt wird, mit zumindest einer der Vielzahl an Messpositionen, und/oder insbesondere der aktuellen Messposition der Vielzahl an Messpositionen.

Es kann vorkommen, dass Kartendaten teilweise unzureichend und/oder ungenau sind, beispielsweise weil diese aus alten (analogen) Karten übernommen wurden und/oder weil sich (tatsächlich) Änderungen in der Leitungsposition ergeben haben (etwa aufgrund von Bauarbeiten, Erdrutsch, Bergschäden et cetera). Ein einfaches Beispiel ist eine Leitung, welche fälschlicherweise auf der falschen Straßenseite in den Kartendaten eingezeichnet bzw. gespeichert ist. Dies kann, insbesondere beim Messen (anhand des Messplans), durch den Benutzer und/oder das mobile Endgerät festgestellt werden. Am einfachsten kann dies beispielsweise festgestellt werden, wenn (mit dem identischen oder einem vergleichbaren Messsystem) bereits in der Vergangenheit ("historisch") ein Messen durchgeführt wurde. Das mobile Endgerät kann dies beispielsweise anhand der Kartendaten und/oder anhand von historischen Kartendaten und/oder Messinformationen feststellen. Demnach können beispielsweise (zur Validierung und/oder zum Feststellen von Abweichungen) eine oder mehrere (historische) Messpositionen übernommen werden bzw. neu vermessen werden, beispielsweise indem diese (erneut) von der Vielzahl von Messpositionen umfasst sind. Wenn beispielsweise ein (nachweislich) intakter Leitungsabschnitt an identischen Messpositionen (also, wenn aktuelle Messpositionen mit historischen Messpositionen übereinstimmen) vermessen wird und sich (einen Grenzwert z. B. von mehr 50%) große Abweichungen in den Messwerten ergeben, kann ein Nachjustieren der Kartendaten erfolgen. Aktualisierte Kartendaten können beispielsweise dadurch bereitgestellt werden, dass weitere Messpositionen von dem mobilen Endgerät ermittelt werden, um die (wahrscheinlichste und/oder tatsächliche) Position der Leitung zu ermitteln. Dies kann beispielsweise im Rahmen eins Random-Walks und/oder anhand von Wahrscheinlichkeitsverteilungen basierend auf den historischen und aktuellen Messdaten ermittelt werden. Es kann vorgesehen sein, dass das Nachjustieren für einen oder mehrere Leitungsabschnitte und/oder eine Vielzahl an (Mess- )Positionen durchgeführt wird. Es kann vorgesehen sein, dass die aktualisierten Kartendaten, beispielsweise über eine (zweite) Datenverbindung, an eine Backend-Recheneinheit übermittelt werden, wodurch diese vorzugsweise ein Verteilen (z. B. über das Internet) an andere Messsysteme und/oder (weitere) mobile Endgeräte ermöglicht.

Im Rahmen der Erfindung ist es denkbar, dass das Nachjustieren ein Verifizieren aufweist, umfassend:
- Übermitteln der aktualisierten Kartendaten an eine Backend-Recheneinheit, insbesondere über eine zweite Datenverbindung, beispielsweise das Internet, und/oder
- Überprüfen der aktualisierten Kartendaten durch die Backend-Recheneinheit.

Es kann vorgesehen sein, dass die aktualisierten Kartendaten, beispielsweise über eine (zweite) Datenverbindung, an eine Backend-Recheneinheit übermittelt werden, wodurch diese vorzugsweise ein Validieren (z. B. durch Datenabgleich mit anderen Karten und/oder Messungen) durchführen kann. Beispielsweise kann eine Backend-Recheneinheit Daten von anderen Messsystemen und/oder anderen Anbietern sammeln, welche beispielsweise eine (kürzlich) veränderte Leitungsposition bestätigen können. Dabei kann ein iteratives und/oder automatisches Updaten der Kartendaten auf sämtlichen bzw. anderen / weiteren mobilen Endgeräten und/oder Messsystemen erfolgen. So kann vorteilhafterweise ein schnelleres und/oder effizienteres und/oder genaueres Vermessen eines bestimmten Gebiets erfolgen, beispielsweise durch zumindest zwei oder eine Vielzahl an Benutzern, mobile Endgeräte und/oder Messsysteme. Dies kann vorteilhaft sein, wenn beispielsweise Kartendaten in einem bestimmten zu erschließenden Gebiet nur teilweise bekannt und/oder (bekanntermaßen) unzuverlässig / veraltet sind. Dadurch können auf effiziente Weise (vollständige und/oder verifizierte) aktualisierte Kartendaten erzeugt werden.

Es kann im Rahmen der Erfindung vorgesehen sein, dass das Nachjustieren der Kartendaten ein Übermitteln der aktualisierten Kartendaten an zumindest ein weiteres mobiles Endgerät umfasst, wobei insbesondere das Übermitteln durchgeführt wird:
- von dem mobilen Endgerät an das weitere mobile Endgerät, insbesondere über eine (direkte) dritte Datenverbindung (etwa Bluetooth und/oder WLAN), und/oder
- von der Backend-Recheneinheit an das weitere mobile Endgerät, insbesondere über eine vierte Datenverbindung, beispielsweise das Internet.

Es kann vorgesehen sein, dass ein Übermitteln der aktualisierten, und insbesondere überprüften, Kartendaten an zumindest ein weiteres mobiles Endgerät erfolgt. Dies kann vorteilhafterweise (insgesamt) die Effizienz und/oder Geschwindigkeit erhöhen, beispielsweise wenn mehrere Benutzer mit mobilen Endgeräten und/oder Messsystemen (gemeinsam) ein Gebiet vermessen.

Es ist ferner denkbar, dass das Messen durch die Messvorrichtung und die Steuereinheit in Kombination mit einer weiteren Messvorrichtung und einer dieser zugeordneten weiteren Steuereinheit durchgeführt wird, wobei insbesondere die weitere Steuereinheit über eine fünfte Datenverbindung datenkommunizierend verbunden ist mit:
- dem mobilen Endgerät, und/oder
- zumindest (dem) einen weiteren mobilen Endgerät.

Dadurch können diese eine gemeinsame und/oder kombinierte Messung durchführen. Beispielsweise kann ein weiteres Messsystem und/oder eine weitere Messvorrichtung für eine Potentialmessung (z. B. als zweite Elektrode und/oder als Referenz) verwendet werden, wobei vorzugsweise eine Potentialdifferenz zwischen Messvorrichtung (etwa einem ersten Erdspieß) und der weiteren Messvorrichtung (etwa einem zweiten Erdspieß) (durch das Messen) ermittelt werden kann. Dadurch können vorteilhafterweise auch zwei oder mehr Messsysteme und/oder Messvorrichtungen von einem (einzigen) Benutzer bedient werden, welcher beispielsweise anhand seines (einzigen) mobilen Endgeräts die unterschiedlichen Messvorrichtungen positioniert und anschließend ein Messen durch das mobile Endgerät durchführt bzw. initiiert wird.

Es kann dabei vorgesehen sein, dass ein (erstes) mobiles Endgerät, beispielsweise in einer Halterung eines Messsystems und/oder einer Messvorrichtung, angeordnet ist und/oder mit einem weiteren/zweiten mobilen Endgerät, insbesondere (in einer Halterung) einer weiteren/zweiten Messvorrichtung, datenkommunizierend verbunden ist, beispielsweise über eine dritte Datenverbindung, etwa ein Kabel und/oder kabellos (z. B. WLAN, siehe oben). Dabei kann die weitere Messvorrichtung eine (eigene bzw. weitere) Steuereinheit aufweisen, welche z. B. identisch zu der Steuereinheit ausgebildet ist. Demnach kann auch ein Verbinden zwischen dem mobilen Endgerät und der weiteren Steuereinheit, insbesondere in gleicher Weise, erfolgen (siehe oben). Zudem kann das weitere/zweite mobile Endgerät, insbesondere über eine vierte Datenverbindung (etwa das Internet), mit einer Backend-Recheneinheit verbunden sein. Dadurch kann auch eine Kommunikation über die Backend-Recheneinheit ermöglicht werden.

Es ist auch denkbar, dass das mobile Endgerät (direkt), insbesondere über eine fünfte Datenverbindung kabelgebunden oder kabellos (etwa über WLAN und/oder Bluetooth und/oder NFC) mit der weiteren Steuereinheit datenkommunizierend verbunden ist. Dadurch kann die Anzahl der mobilen Endgeräte reduziert werden, was die Kosten und/oder die Einfachheit verbessern kann.

Die obenstehende Aufgabe wird gemäß einem zweiten Aspekt gelöst durch ein erfindungsgemäßes Messsystem, aufweisend:
- eine Steuereinheit, beispielsweise eine Erdschlusssonde,
- eine Messvorrichtung, beispielsweise einen Erdspieß und/oder eine Elektrode, welche eingerichtet und von der Steuereinheit ansteuerbar ist zum Messen von Messwerten, beispielsweise eines Potentials,
- wobei das Messsystem und/oder die Steuereinheit, insbesondere zusammen mit einem mobilen Endgerät eines Benutzers, eingerichtet ist, das Verfahren nach einem der vorhergehenden Ansprüche durchzuführen.

Damit ergeben sich in Bezug auf ein erfindungsgemäßes Messsystem gemäß dem zweiten Aspekt die gleichen Vorteile, wie sie bereits in Bezug auf ein erfindungsgemäßes Verfahren gemäß dem ersten Aspekt beschrieben worden sind.

Weitere Vorteile, Merkmale und Einzelheiten der Erfindung ergeben sich aus der nachfolgenden Beschreibung, in der unter Bezugnahme auf die Zeichnungen mehrere Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Dabei zeigen beispielhaft
- Fig. 1: ein Verfahren,
- Fig. 2: ein Messsystem 1000,
- Fig. 3: ein Messsystem 1000, und
- Fig. 4: ein Messsystem 1000.

In den Figuren werden für die gleichen technischen Merkmale, auch von unterschiedlichen Ausführungsbeispielen, die identischen Bezugszeichen verwendet.

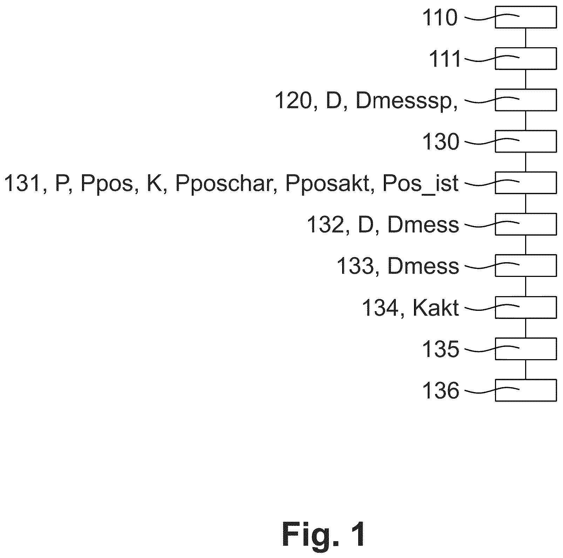

Fig. 1 zeigt beispielhaft ein Verfahren zum Betreiben eines elektronischen Messsystems 1000, welches insbesondere portabel und/oder durch einen Benutzer tragbar ausgestaltet ist, das Messsystem 1000 aufweisend:
- eine Steuereinheit ECU, beispielsweise eine Erdschlusssonde,
- eine Messvorrichtung 100, beispielsweise einen Erdspieß und/oder eine Elektrode, welche eingerichtet und von der Steuereinheit ECU ansteuerbar ist zum Messen 133 von Messwerten Dmess, welche spezifisch sind für eine unterhalb der Messvorrichtung 100, insbesondere im Untergrund 1, verlaufende Leitung 2,
das Verfahren aufweisend:
- Verbinden 110 eines mobilen Endgeräts M1 eines Benutzers mit einer Datenschnittstelle M1con der Steuereinheit ECU des Messsystems 1000 um eine Datenverbindung Con1 zwischen dem mobilen Endgerät M1 und der Datenschnittstelle M1con der Steuereinheit ECU bereitzustellen,
- Übertragen 120 von Daten D von der Steuereinheit ECU des Messsystems 1000 über die Datenverbindung Con1 an das mobile Endgerät M1,
- Betreiben 130 des mobilen Endgeräts M1 in Abhängigkeit von den Daten D.

Im Rahmen der Erfindung kann es von Vorteil sein, dass das Verbinden 110 ein mechanisches Anordnen 111 des mobilen Endgeräts M1 in einer dafür eingerichteten Halterung 10 aufweist, wobei die Halterung 10 an dem Messsystem 1000, insbesondere an der Steuereinheit ECU, angeordnet ist, wobei vorzugsweise gleichzeitig das mechanische Anordnen 111 und das Verbinden 110 des mobilen Endgeräts M1 mit der Datenschnittstelle M1con durchgeführt wird.

Im Rahmen der Erfindung ist es denkbar, dass bei dem Übertragen 120 die Daten D von der Steuereinheit ECU über die Datenverbindung Con1 an das mobile Endgerät M1 übermittelt werden, und das Betreiben 130 ein Visualisieren 132 der Daten D, insbesondere von Messwerten Dmess, auf einer Anzeigeeinheit des mobilen Endgeräts M1 umfasst.

Es kann im Rahmen der Erfindung vorgesehen sein, dass bei dem Übertragen 120 von Daten D zumindest eine Messspezifikation Dmesssp von der Steuereinheit ECU über die Datenverbindung Con1 an das mobile Endgerät M1 übermittelt wird, wobei die zumindest eine Messspezifikation Dmesssp für das Messsystem 1000, insbesondere ein Messen 133 des Messsystems 1000, spezifisch ist, wobei vorzugsweise die zumindest eine Messspezifikation Dmesssp aufweist:
- eine, insbesondere abstandsabhängige, Messgenauigkeit,
- eine Messauflösung,
- eine Reichweite, und/oder
- zumindest eine Temperatur, insbesondere einen Temperaturbereich, für ein Messen 133.

Es ist ferner denkbar, dass das Betreiben 130 des mobilen Endgeräts M1 in Abhängigkeit von den Daten D durchgeführt wird, wobei das mobile Endgerät M1, insbesondere in Abhängigkeit von der zumindest einen Messspezifikation Dmesssp, ein Bereitstellen 131 eines Messplans P durchführt, umfassend:
- eine Vielzahl von Messpositionen Ppos für das Messen 133 an spezifischen Positionen, insbesondere oberhalb des Untergrunds 1, insbesondere in Abhängigkeit von in dem mobilen Endgerät M1 gespeicherten Kartendaten K, und
- wobei insbesondere jede der Vielzahl von Messpositionen Ppos zumindest eine, insbesondere für ein Messen 133 spezifische, Messcharakteristik Pposchar aufweist, insbesondere eine Messreihenfolge, eine Messzeit und/oder eine Messart.

Auch ist es denkbar, dass das Betreiben 130 des mobilen Endgeräts M1, insbesondere das Bereitstellen 131 des Messplans P, ein Anzeigen des Messplans P umfasst, insbesondere der Vielzahl von Messpositionen Ppos von welchen eine aktuelle Messposition Pposakt dargestellt wird, beispielsweise auf einer Anzeigeeinheit des mobilen Endgeräts M1, wobei vorzugsweise eine Bewegungsrichtung hin zu der aktuellen Messposition Pposakt in Abhängigkeit von einer durch das mobile Endgerät M1 ermittelten Ist-Position Pos_ist dargestellt wird.

Im Rahmen der Erfindung ist es optional möglich, dass bei dem Betreiben 130, insbesondere dem Anzeigen, der Benutzer an zumindest einer der Vielzahl von Messpositionen Ppos, insbesondere an einer aktuellen Messposition Pposakt der Vielzahl an Messpositionen Ppos, ein Messen 133 von Messwerten Dmess mit dem Messsystem 1000 durchführt.

Ferner kann es im Rahmen der Erfindung vorgesehen sein, dass bei dem Messen 133 ein Ansteuern 133.1 der Messvorrichtung 100 und/oder der Steuereinheit ECU durch das mobile Endgerät M1 durchgeführt wird, woraufhin vorzugsweise die Messvorrichtung 100, insbesondere durch die Steuereinheit ECU, zumindest einen Messwert Dmess ermittelt und an die Steuereinheit ECU überträgt, welche insbesondere den zumindest einen Messwert Dmess an das mobile Endgerät M1 übermittelt.

In Bezug auf die vorliegende Erfindung ist es vorstellbar, dass das Betreiben 130, wenn die aktuelle Messposition Pposakt nicht mit der durch das mobile Endgerät M1 ermittelten Ist-Position Pos_ist übereinstimmt, umfasst:
- Sperren des Messens 133, insbesondere durch das mobile Endgerät M1, und/oder
- Ausgeben eines akustischen Warnsignals durch das mobile Endgerät M1 an den Benutzer, und/oder,
- Anzeigen, insbesondere auf einer Anzeigeeinheit des mobilen Endgeräts M1, einer Fehlermeldung und/oder insbesondere einer Anleitung zur Behebung des Sperrens.

Ferner ist es vorstellbar, dass in dem mobilen Endgerät M1 bereitgestellte Kartendaten K vorgesehen sind, welche zumindest spezifisch sind für den Verlauf zumindest einer Leitung 2, insbesondere im Untergrund 1 unterhalb der Messvorrichtung 100, wobei insbesondere der Messplan P spezifisch ist für die Kartendaten K, insbesondere den Verlauf der zumindest einen Leitung 2, und vorzugsweise die Vielzahl von Messpositionen Ppos entlang und/oder oberhalb von der zumindest einen Leitung 2 aufweist.

Im Rahmen der Erfindung kann es von Vorteil sein, dass, insbesondere bei und/oder nach dem Betreiben 130, ein Nachjustieren 134 der Kartendaten K durchgeführt wird, insbesondere in Abhängigkeit von den Messwerten Dmess, wobei der Verlauf der zumindest einen Leitung 2 in den Kartendaten K zumindest teilweise durch einen aktualisierten Verlauf der zumindest einen Leitung 2 in den Kartendaten K angepasst wird, um aktualisierte Kartendaten Kakt zu erhalten, wobei insbesondere das Nachjustieren 134 umfasst:
- ein Vergleichen der Messwerte Dmess mit historischen Messwerten, vorzugsweise an einer identischen Messposition, und/oder
- ein Vergleichen einer Ist-Position Pos_ist, welche vorzugsweise durch eine Ortungseinheit, beispielsweise einen GPS-Sensor, des mobilen Endgeräts M1 bestimmt wird, mit zumindest einer der Vielzahl an Messpositionen Ppos, und/oder insbesondere der aktuellen Messposition Pposakt der Vielzahl an Messpositionen Ppos.

Im Rahmen der Erfindung ist es denkbar, dass das Nachjustieren 134 ein Verifizieren 135 aufweist, umfassend:
- Übermitteln 136 der aktualisierten Kartendaten Kakt an eine Backend-Recheneinheit 300, insbesondere über eine zweite Datenverbindung Con2, beispielsweise das Internet, und/oder
- Überprüfen der aktualisierten Kartendaten Kakt durch die Backend-Recheneinheit 300.

Es kann im Rahmen der Erfindung vorgesehen sein, dass das Nachjustieren 134 der Kartendaten K ein Übermitteln 136 der aktualisierten Kartendaten Kakt an zumindest ein weiteres mobiles Endgerät M2 umfasst, wobei insbesondere das Übermitteln 136 durchgeführt wird:
- von dem mobilen Endgerät M1 an das weitere mobile Endgerät M2, insbesondere über eine dritte Datenverbindung Con3, und/oder
- von der Backend-Recheneinheit 300 an das weitere mobile Endgerät M2, insbesondere über eine vierte Datenverbindung Con4, beispielsweise das Internet.

Es ist ferner denkbar, dass das Messen 133 durch die Messvorrichtung 100 und die Steuereinheit ECU in Kombination mit einer weiteren Messvorrichtung 100' und einer dieser zugeordneten weiteren Steuereinheit ECU' durchgeführt wird, wobei insbesondere die weitere Steuereinheit ECU' über eine fünfte Datenverbindung Con5 datenkommunizierend verbunden ist mit:
- dem mobilen Endgerät M1, und/oder
- zumindest einem weiteren mobilen Endgerät M2.

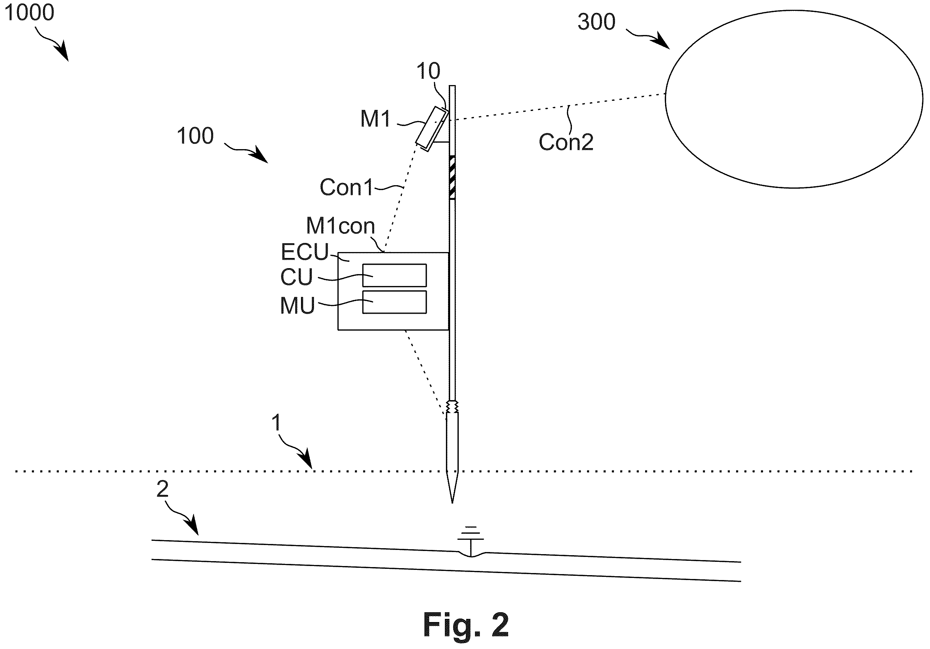

Fig. 2 zeigt beispielhaft ein erfindungsgemäßes Messsystem 1000 aufweisend:
- eine Steuereinheit ECU, beispielsweise eine Erdschlusssonde, welche insbesondere eine Recheneinheit CU und/oder eine Speichereinheit MU aufweist,
- eine Messvorrichtung 100, beispielsweise einen Erdspieß und/oder eine Elektrode, welche eingerichtet und von der Steuereinheit ECU ansteuerbar ist zum Messen 133 von Messwerten Dmess, beispielsweise eines Potentials, welches vorzugsweise spezifisch ist für eine (elektrische) Leitung 2, welche insbesondere unterhalb der Messvorrichtung 100 und/oder dem Untergrund 1 verläuft,
- wobei das Messsystem 1000 und/oder die Steuereinheit ECU, insbesondere zusammen mit einem mobilen Endgerät M1 eines Benutzers, eingerichtet ist, das Verfahren nach einem der vorhergehenden Ansprüche durchzuführen.

Dabei kann die Steuereinheit ECU das Messen 133 durchführen und/oder eine Elektrode bzw. einen Erdspieß ansteuern bzw. mit einem Strom und/oder Potential (zum Messen) beaufschlagen und/oder einen Strom und/oder eine (an diesem anliegende) Spannung bzw. eine Potentialdifferenz zu detektieren. Demnach kann die Steuereinheit ECU auch eine Spannungs- und/oder Stromquelle aufweisen und/oder als solche ausgestaltet sein (insbesondere umfassend einen Energiespeicher, etwa einen Akkumulator). Demnach kann die Steuereinheit ECU auch eine Spannungs- und/oder Strommesseinheit aufweisen und/oder als solche ausgestaltet sein.

Die Steuereinheit ECU kann, insbesondere über eine Datenverbindung Con1, mit dem mobilen Endgerät M1 datenkommunizierend verbunden sein. Dabei kann das mobile Endgerät M1 in einer Halterung 10 angeordnet sein.

Das mobile Endgerät M1 kann, insbesondere über eine zweite Datenverbindung Con2, etwa das Internet, datenkommunizierend verbunden sein mit einer Backend-Recheneinheit 300.

Durch das Messen 133 bzw. in Abhängigkeit von den Messwerten Dmess, kann das mobile Endgerät M1 einen Defekt der Leitung 2 ermitteln, beispielsweise einen Erdschluss bzw. einen Kurzschluss zum Erdpotential.

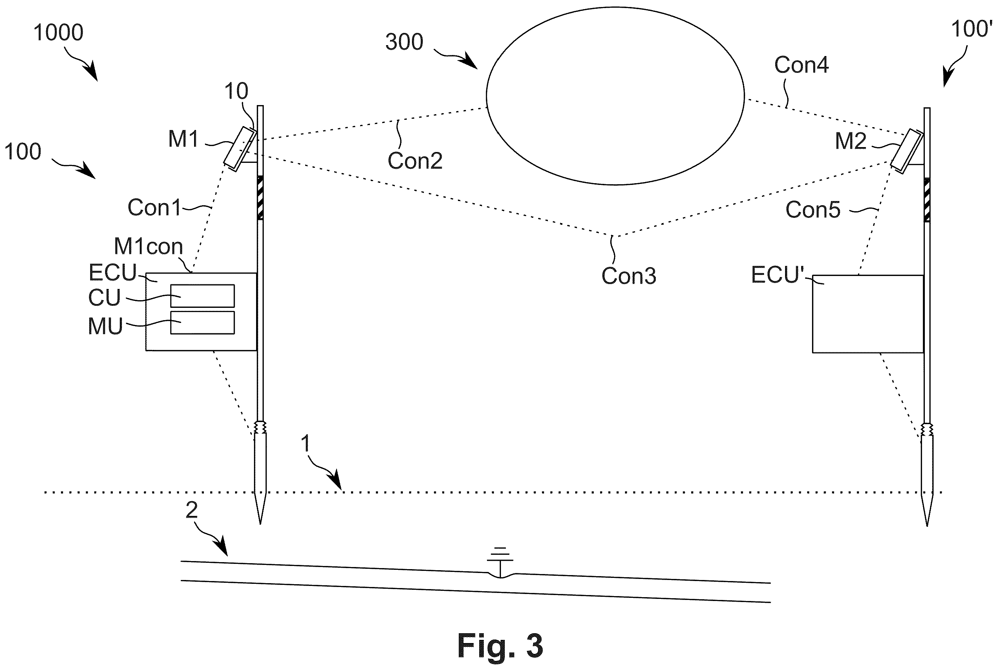

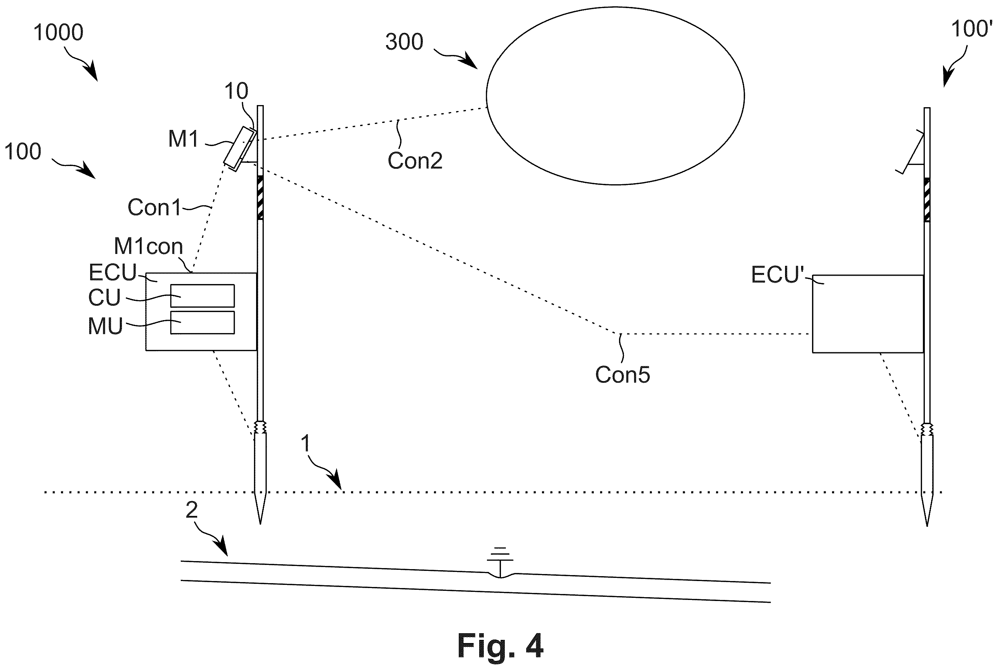

Fig. 3 und Fig. 4 zeigen beispielhaft eine weitere Messvorrichtung 100' umfassend eine weitere Steuereinheit ECU', welche insbesondere identisch zu der Steuereinheit ECU ausgestaltet sein kann (siehe oben). Im Wesentlichen kann die weitere Messvorrichtung 100' dabei identisch zu der Messvorrichtung 100 ausgestaltet sein und/oder diese (messtechnisch) ergänzen. So kann beispielsweise bei einem Messsystem 1000 zum Ermitteln eines Erdschlusses, eine Potentialmessung zwischen der Messvorrichtung 100, insbesondere einer Elektrode bzw. einem (ersten) Erdspieß, und der weiteren Messvorrichtung 100', insbesondere einer entsprechenden Elektrode bzw. einem (zweiten) Erdspieß, durchgeführt werden.

Fig. 3 zeigt dabei, dass die weitere Steuereinheit ECU', insbesondere über eine fünfte Datenverbindung Con5, datenkommunizierend verbunden sein kann mit einem weiteren mobilen Endgerät M2. Das weitere mobile Endgerät M2 kann, insbesondere über eine dritte Datenverbindung Con3, datenkommunizierend verbunden sein mit dem mobilen Endgerät M1.

Dadurch kann beispielsweise ein Austausch von Steuersignalen erfolgen, um die Steuereinheit ECU und/oder die weitere Steuereinheit ECU' (gleichzeitig und/oder synchron) anzusteuern. Das weitere mobile Endgerät M2 kann, insbesondere über eine vierte Datenverbindung Con4, datenkommunizierend verbunden sein mit der Backend-Recheneinheit 300. Dadurch können beispielsweise aktualisierte Kartendaten Kakt (direkt) an das weitere mobile Endgerät M2 übermittelt werden.

Fig. 4 zeigt beispielhaft, dass die weitere Steuereinheit ECU', insbesondere über eine fünfte Datenverbindung Con5, (direkt und/oder datenkommunizierend) verbunden sein kann mit dem mobilen Endgerät M1 (der Messvorrichtung). Mit anderen Worten kann ein (einziges) mobiles Endgerät M1 verwendet werden, um die Messvorrichtung 100 und die weitere Messvorrichtung 100' zu bedienen. So kann beispielsweise das mobile Endgerät M1 Steuersignale an die Steuereinheit ECU und/oder die weitere Steuereinheit ECU' übermitteln, wodurch beispielsweise eine synchrone und/oder gleichzeitige und/oder energiesparende Messung ermöglicht werden kann.

### Bezugszeichenliste

- 1: Untergrund
- 2: Leitung
- 10: Halterung
- 100: Messvorrichtung
- 100': weitere Messvorrichtung
- 110: Verbinden
- 111: mechanisches Anordnen
- 120: Übertragen
- 130: Betreiben
- 131: Bereitstellen eines Messplans
- 132: Visualisieren
- 133: Messen
- 133.1: Ansteuern
- 134: Nachjustieren
- 135: Verifizieren
- 136: Übermitteln
- 300: Backend-Recheneinheit
- 1000: Messsystem
- Con1: Datenverbindung
- Con2: zweite Datenverbindung
- Con3: dritte Datenverbindung
- Con4: vierte Datenverbindung
- Con5: fünfte Datenverbindung
- D: Daten
- Dmess: Messwerte
- Dmesssp: Messspezifikation
- ECU: Steuereinheit
- CU: Recheneinheit
- MU: Speichereinheit
- ECU': weitere Steuereinheit
- K: Kartendaten
- Kakt: aktualisierte Kartendaten
- M1: mobiles Endgerät
- M1con: Datenschnittstelle
- M2: weiteres mobiles Endgerät
- P: Messplan
- Pos_ist: Ist-Position
- Ppos: Vielzahl von Messpositionen
- Pposakt: aktuelle Messposition
- Pposchar: Messcharakteristik

## Patentansprüche

1. Verfahren zum Betreiben eines elektronischen Messsystems (1000), welches insbesondere portabel und/oder durch einen Benutzer tragbar ausgestaltet ist, das Messsystem (1000) aufweisend:
- eine Steuereinheit (ECU), beispielsweise eine Erdschlusssonde,
- eine Messvorrichtung (100), beispielsweise einen Erdspieß und/oder eine Elektrode, welche eingerichtet und von der Steuereinheit (ECU) ansteuerbar ist zum Messen (133) von Messwerten (Dmess), welche spezifisch sind für eine unterhalb der Messvorrichtung (100), insbesondere im Untergrund (1), verlaufende Leitung (2), das Verfahren aufweisend:
- Verbinden (110) eines mobilen Endgeräts (M1) eines Benutzers mit einer Datenschnittstelle (M1con) der Steuereinheit (ECU) des Messsystems (1000) um eine Datenverbindung (Con1) zwischen dem mobilen Endgerät (M1) und der Datenschnittstelle (M1con) der Steuereinheit (ECU) bereitzustellen,
- Übertragen (120) von Daten (D) von der Steuereinheit (ECU) des Messsystems (1000) über die Datenverbindung (Con1) an das mobile Endgerät (M1),
- Betreiben (130) des mobilen Endgeräts (M1) in Abhängigkeit von den Daten (D).

2. Verfahren nach Anspruch 1,
**dadurch gekennzeichnet,**
**dass** das Verbinden (110) ein mechanisches Anordnen (111) des mobilen Endgeräts (M1) in einer dafür eingerichteten Halterung (10) aufweist, wobei die Halterung (10) an dem Messsystem (1000), insbesondere an der Steuereinheit (ECU), angeordnet ist, wobei vorzugsweise gleichzeitig das mechanische Anordnen (111) und das Verbinden (110) des mobilen Endgeräts (M1) mit der Datenschnittstelle (M1con) durchgeführt wird.

3. Verfahren nach einem der vorhergehenden Ansprüche,
**dadurch gekennzeichnet,**
**dass** bei dem Übertragen (120) die Daten (D) von der Steuereinheit (ECU) über die Datenverbindung (Con1) an das mobile Endgerät (M1) übermittelt werden, und das Betreiben (130) ein Visualisieren (132) der Daten (D), insbesondere von Messwerten (Dmess), auf einer Anzeigeeinheit des mobilen Endgeräts (M1) umfasst.

4. Verfahren nach einem der vorhergehenden Ansprüche,
**dadurch gekennzeichnet,**
**dass** bei dem Übertragen (120) von Daten (D) zumindest eine Messspezifikation (Dmesssp) von der Steuereinheit (ECU) über die Datenverbindung (Con1) an das mobile Endgerät (M1) übermittelt wird, wobei die zumindest eine Messspezifikation (Dmesssp) für das Messsystem (1000), insbesondere ein Messen (133) des Messsystems (1000), spezifisch ist, wobei vorzugsweise die zumindest eine Messspezifikation (Dmesssp) aufweist:
- eine, insbesondere abstandsabhängige, Messgenauigkeit,
- eine Messauflösung,
- eine Reichweite, und/oder
- zumindest eine Temperatur, insbesondere einen Temperaturbereich, für ein Messen (133).

5. Verfahren nach einem der vorhergehenden Ansprüche,
**dadurch gekennzeichnet,**
**dass** das Betreiben (130) des mobilen Endgeräts (M1) in Abhängigkeit von den Daten (D) durchgeführt wird, wobei das mobile Endgerät (M1), insbesondere in Abhängigkeit von der zumindest einen Messspezifikation (Dmesssp), ein Bereitstellen (131) eines Messplans (P) durchführt, umfassend:
- eine Vielzahl von Messpositionen (Ppos) für das Messen (133) an spezifischen Positionen, insbesondere oberhalb des Untergrunds (1), insbesondere in Abhängigkeit von in dem mobilen Endgerät (M1) gespeicherten Kartendaten (K), und
- wobei insbesondere jede der Vielzahl von Messpositionen (Ppos) zumindest eine, insbesondere für ein Messen (133) spezifische, Messcharakteristik (Pposchar) aufweist, insbesondere eine Messreihenfolge, eine Messzeit und/oder eine Messart.

6. Verfahren nach dem vorhergehenden Anspruch,
**dadurch gekennzeichnet,**
**dass** das Betreiben (130) des mobilen Endgeräts (M1), insbesondere das Bereitstellen (131) des Messplans (P), ein Anzeigen des Messplans (P) umfasst, insbesondere der Vielzahl von Messpositionen (Ppos) von welchen eine aktuelle Messposition (Pposakt) dargestellt wird, beispielsweise auf einer Anzeigeeinheit des mobilen Endgeräts (M1), wobei vorzugsweise eine Bewegungsrichtung hin zu der aktuellen Messposition (Pposakt) in Abhängigkeit von einer durch das mobile Endgerät (M1) ermittelten Ist-Position (Pos_ist) dargestellt wird.

7. Verfahren nach einem der vorhergehenden Ansprüche 5 oder 6,
**dadurch gekennzeichnet,**
**dass** bei dem Betreiben (130), insbesondere dem Anzeigen, der Benutzer an zumindest einer der Vielzahl von Messpositionen (Ppos), insbesondere an einer aktuellen Messposition (Pposakt) der Vielzahl an Messpositionen (Ppos), ein Messen (133) von Messwerten (Dmess) mit dem Messsystem (1000) durchführt.

8. Verfahren nach Anspruch 7,
**dadurch gekennzeichnet,**
**dass** bei dem Messen (133) ein Ansteuern (133.1) der Messvorrichtung (100) und/oder der Steuereinheit (ECU) durch das mobile Endgerät (M1) durchgeführt wird, woraufhin vorzugsweise die Messvorrichtung (100), insbesondere durch die Steuereinheit (ECU), zumindest einen Messwert (Dmess) ermittelt und an die Steuereinheit (ECU) überträgt, welche insbesondere den zumindest einen Messwert (Dmess) an das mobile Endgerät (M1) übermittelt.

9. Verfahren nach einem der vorhergehenden Ansprüche 6 bis 8,
**dadurch gekennzeichnet,**
**dass** das Betreiben (130), wenn die aktuelle Messposition (Pposakt) nicht mit der durch das mobile Endgerät (M1) ermittelten Ist-Position (Pos_ist) übereinstimmt, umfasst:
- Sperren des Messens (133), insbesondere durch das mobile Endgerät (M1), und/oder
- Ausgeben eines akustischen Warnsignals durch das mobile Endgerät (M1) an den Benutzer, und/oder,
- Anzeigen, insbesondere auf einer Anzeigeeinheit des mobilen Endgeräts (M1), einer Fehlermeldung, und/oder insbesondere einer Anleitung zur Behebung des Sperrens.

10. Verfahren nach einem der vorhergehenden Ansprüche,
**dadurch gekennzeichnet,**
**dass** in dem mobilen Endgerät (M1) bereitgestellte Kartendaten (K) vorgesehen sind, welche zumindest spezifisch sind für den Verlauf zumindest einer Leitung (2), insbesondere im Untergrund (1) unterhalb der Messvorrichtung (100), wobei insbesondere der Messplan (P) spezifisch ist für die Kartendaten (K), insbesondere den Verlauf der zumindest einen Leitung (2), und vorzugsweise die Vielzahl von Messpositionen (Ppos) entlang und/oder oberhalb von der zumindest einen Leitung (2) aufweist.

11. Verfahren nach dem vorhergehenden Anspruch,
**dadurch gekennzeichnet,**
**dass**, insbesondere bei und/oder nach dem Betreiben (130), ein Nachjustieren (134) der Kartendaten (K) durchgeführt wird, insbesondere in Abhängigkeit von den Messwerten (Dmess), wobei der Verlauf der zumindest einen Leitung (2) in den Kartendaten (K) zumindest teilweise durch einen aktualisierten Verlauf der zumindest einen Leitung (2) in den Kartendaten (K) angepasst wird, um aktualisierte Kartendaten (Kakt) zu erhalten, wobei insbesondere das Nachjustieren (134) umfasst:
- ein Vergleichen der Messwerte (Dmess) mit historischen Messwerten, vorzugsweise an einer identischen Messposition, und/oder
- ein Vergleichen einer Ist-Position (Pos_ist), welche vorzugsweise durch eine Ortungseinheit, beispielsweise einen GPS-Sensor, des mobilen Endgeräts (M1) bestimmt wird, mit zumindest einer der Vielzahl an Messpositionen (Ppos), und/oder insbesondere der aktuellen Messposition (Pposakt) der Vielzahl an Messpositionen (Ppos).

12. Verfahren nach dem vorhergehenden Anspruch,
**dadurch gekennzeichnet,**
**dass** das Nachjustieren (134) ein Verifizieren (135) aufweist, umfassend:
- Übermitteln (136) der aktualisierten Kartendaten (Kakt) an eine Backend-Recheneinheit (300), insbesondere über eine zweite Datenverbindung (Con2), beispielsweise das Internet, und/oder
- Überprüfen der aktualisierten Kartendaten (Kakt) durch die Backend-Recheneinheit (300).

13. Verfahren nach einem der vorhergehenden Ansprüche 11 oder 12,
**dadurch gekennzeichnet,**
**dass** das Nachjustieren (134) der Kartendaten (K) ein Übermitteln (136) der aktualisierten Kartendaten (Kakt) an zumindest ein weiteres mobiles Endgerät (M2) umfasst, wobei insbesondere das Übermitteln (136) durchgeführt wird:
- von dem mobilen Endgerät (M1) an das weitere mobile Endgerät (M2), insbesondere über eine dritte Datenverbindung (Con3), und/oder
- von der Backend-Recheneinheit (300) an das weitere mobile Endgerät (M2), insbesondere über eine vierte Datenverbindung (Con4), beispielsweise das Internet.

14. Verfahren nach einem der vorhergehenden Ansprüche,
**dadurch gekennzeichnet,**
**dass** das Messen (133) durch die Messvorrichtung (100) und die Steuereinheit (ECU) in Kombination mit einer weiteren Messvorrichtung (100') und einer dieser zugeordneten weiteren Steuereinheit (ECU') durchgeführt wird, wobei insbesondere die weitere Steuereinheit (ECU') über eine fünfte Datenverbindung (Con5) datenkommunizierend verbunden ist mit:
- dem mobilen Endgerät (M1), und/oder
- zumindest einem weiteren mobilen Endgerät (M2).

15. Messsystem (1000) aufweisend:
- eine Steuereinheit (ECU), beispielsweise eine Erdschlusssonde,
- eine Messvorrichtung (100), beispielsweise einen Erdspieß und/oder eine Elektrode, welche eingerichtet und von der Steuereinheit (ECU) ansteuerbar ist zum Messen (133) von Messwerten (Dmess), beispielsweise eines Potentials,
- wobei das Messsystem (1000) und/oder die Steuereinheit (ECU), insbesondere zusammen mit einem mobilen Endgerät (M1) eines Benutzers, eingerichtet ist, das Verfahren nach einem der vorhergehenden Ansprüche durchzuführen.
